# EUROPEAN PATENT APPLICATION

(11) **EP 2 648 224 A1**
(43) Date of publication of application: **09.10.2013**
(21) Application number: 11845908.0
(22) Date of filing: 25.11.2011
(51) Int. Cl.: H01L 31/04

(54) **SOLAR BATTERY CELL AND SOLAR BATTERY MODULE**

(30) Priority: 29.11.2010 JP 2010265592
(71) Applicant: Sanyo Electric Co., Ltd., Osaka 570-8677 (JP)
(72) Inventor: BABA, Toshiaki, Moriguchi-shi Osaka 570-8677 (JP)
(74) Representative: Glawe, Delfs, Moll
(86) International application number: PCT/JP2011/077132
(87) International publication number: WO 2012/073801

(57) **Abstract**

A solar battery cell and a solar battery module are provided with improved photoelectric conversion efficiency. An electrode (21a) includes a plurality of linear electrode portions (31) and trapezoidal electrode portions (32a, 32b). The trapezoidal electrode portions (32a, 32b) are provided in end portions (20a2, 20a3). The trapezoidal electrode portions (32a, 32b) include upper floor portions (32a1, 32b1), lower floor portions (32a2, 32b2), and pairs of oblique portions (32a3, 32a4, 32b3, 32b4). The pairs of oblique portions (32a3, 32a4, 32b3, 32b4) connect the end portions of the upper floor portions (32a1, 32b1) to the end portions of the lower floor portions (32a2, 32b2). The pairs of oblique portions (32a3, 32a4, 32b3, 32b4) extend along the end sides of beveled corner portions (20A-20D).

## Description

### TECHNICAL FIELD

The present invention relates to a solar battery cell and a solar battery module.

### BACKGROUND ART

In recent years, solar battery cells have garnered a lot of attention as an energy source having a low environmental impact. A solar battery cell has a photoelectric conversion unit for generating carriers such as electrons or holes from received light, and an electrode for collecting the carriers generated by the photoelectric conversion unit. One widely used electrode for collecting carriers, described in Patent Document 1, includes a plurality of linear finger-like electrode portions extending on the main surface of the photoelectric conversion unit in one direction and in another direction perpendicular to this direction, and a busbar portion electrically connecting the plurality of finger-like electrode portions.

### PRIOR ART DOCUMENTS

### PATENT DOCUMENTS

Patent Document 1: Laid-Open Patent Publication No. 2010-186862

### SUMMARY OF THE INVENTION

### Problem to be Solved by the Invention

There is increasing demand for greater photoelectric conversion efficiency in solar battery cells.

Therefore, the purpose of the present invention is to provide a solar battery cell and solar battery module with improved photoelectric conversion efficiency.

### Means of Solving the Problem

The solar battery cell of the present invention has a rectangular photoelectric conversion unit with beveled corners, and an electrode. The electrode is provided in the main surface of the photoelectric conversion unit. The main surface of the photoelectric conversion unit includes end portions having beveled corners in a first direction, and a central portion located closer to the center than the beveled corners in the first direction. The electrode includes a plurality of linear electrode portions and a trapezoidal electrode portion. The plurality of linear electrode portions are provided in the central portion. The plurality of linear electrode portions also extend in a second direction perpendicular to the first direction. The trapezoidal electrode portion is provided in an end portion. The trapezoidal electrode portion also includes an upper floor portion and a lower floor portion, as well as a pair of oblique portions. The upper floor portion and lower floor portion extend in the second direction. The pair of oblique portions connect an end portion of the upper floor portion to an end portion of the lower floor portion. A pair of oblique portions extend along the edge sides of a beveled corner.

The solar battery module of the present invention comprises a plurality of solar battery cells of the present invention, and wiring. The wiring electrically connects the plurality of solar battery cells. The wiring is provided so as to intersect the plurality of linear electrode portions.

### Effect of the Invention

The present invention is able to provide a solar battery cell and solar battery module with improved photoelectric conversion efficiency.

### BRIEF DESCRIPTION OF THE DRAWINGS

FIG. 1 is a schematic plan view of the light-receiving surface of the solar battery cell in a first embodiment.
FIG. 2 is a schematic plan view of the rear surface of the solar battery cell in the first embodiment.
FIG. 3 is a schematic cross-sectional view of the portion indicated by line III-III in FIG. 1.
FIG. 4 is an enlarged schematic plan view in which a portion of the light-receiving surface of the solar battery cell in a first comparative example has been expanded.
FIG. 5 is an enlarged schematic plan view in which a V portion of the light-receiving surface of the solar battery cell in the first embodiment has been expanded.
FIG. 6 is a schematic plan view of the light-receiving surface of the solar battery cell in a first modification.
FIG. 7 is a schematic plan view of the light-receiving surface of the solar battery cell in a second modification.
FIG. 8 is a schematic plan view of the light-receiving surface of the solar battery cell in a second embodiment.
FIG. 9 is an enlarged schematic plan view in which a portion of the light-receiving surface of the solar battery cell in a second comparative example has been expanded.
FIG. 10 is an enlarged schematic plan view in which a portion of the light-receiving surface of the solar battery cell in the second embodiment has been expanded.
FIG. 11 is a schematic plan view of the light-receiving surface of the solar battery cell in a third modification.
FIG. 12 is a schematic cross-sectional view of the solar battery cell in a third embodiment.

### EMBODIMENT OF THE PRESENT INVENTION

The following is an explanation of preferred embodiments of the present invention. The following embodiments are merely illustrative. The present invention is not limited to these embodiments.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### (1st Embodiment)

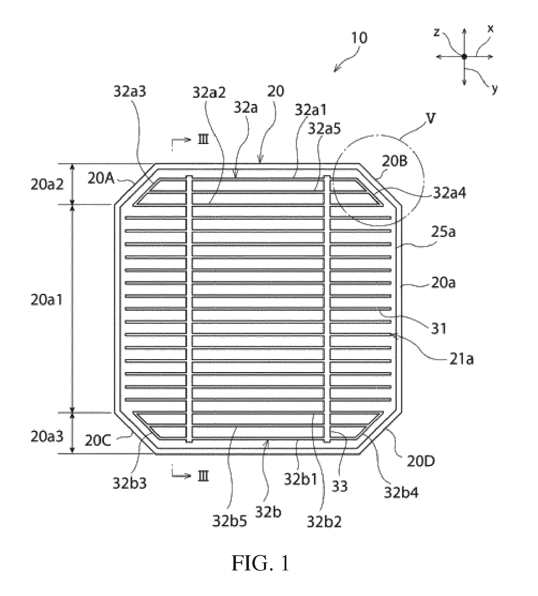

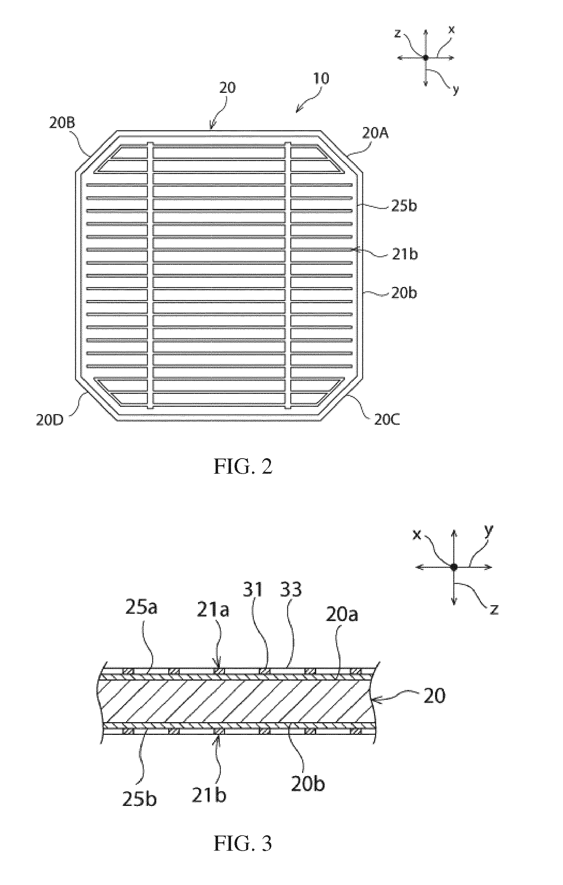

FIG. 1 is a schematic plan view of the light-receiving surface of the solar battery cell in a first embodiment. FIG. 2 is a schematic plan view of the rear surface of the solar battery cell in the first embodiment. FIG. 3 is a schematic cross-sectional view of the portion indicated by line III-III in FIG. 1.

First, the configuration of the solar battery cell 10 in an embodiment will be explained with reference to FIG. 1 through FIG. 3. The solar battery cell 10 has a photoelectric conversion unit 20. The photoelectric conversion unit 20 generates carriers such as electrons and holes from received light. The photoelectric conversion unit 20 may have one conductive type of crystalline semiconductor substrate, and semiconductor junctions such as pn junctions or pin junctions. The photoelectric conversion unit 20 may comprise a crystalline semiconductor substrate having one type of conductivity, a first amorphous semiconductor layer having another type of conductivity provided on the main surface of the crystalline semiconductor substrate, and a second amorphous semiconductor layer provided on another main surface of the crystalline semiconductor substrate having the same type of conductivity as the substrate. Also, the photoelectric conversion unit 20 may comprise a semiconductor substrate having an n-type dopant diffusion region and a p-type dopant diffusion region exposed on the surface.

The photoelectric conversion unit 20 is rectangular with four beveled corners. Here, the photoelectric conversion unit 20 has beveled corners 20A-20D. In other words, both the light-receiving surface 20a and the rear surface 20b of the photoelectric conversion unit 20 are rectangular with four beveled corners.

The light-receiving surface 20a has a first end portion 20a2 in which beveled corners 20A and 20B have been provided in the x direction, a second end portion 20a3 in which beveled corners 20C and 20D have been provided, and a central portion 20a1 located closer to the center than the beveled corners 20A-20D. The rear surface 20b also includes first and second end portions, and a central portion.

A planar transparent conductive film (TCO: transparent conductive oxide) 25a is provided on the light-receiving surface 20a. The transparent conductive film 25a covers the light-receiving surface 20a except along the edges. The transparent conductive film 25b also covers the rear surface 20b except along the edges. The transparent conductive film 25a, 25b assists the electrodes 21a, 21b in carrier collection. By providing transparent conductive film 25a, 25b, the generated carriers are more efficiently collected by the electrodes 21a, 21b before recombining. As a result, improved photoelectric conversion efficiency can be realized.

The transparent conductive film 25a, 25b can be made of indium tin oxide (ITO). The thickness of the transparent conductive film 25a, 25b can be from 50 nm to 150 nm.

An electrode 21a is provided on the light-receiving surface 20a. More specifically, the electrode 21a is provided on top of the transparent conductive film 25a formed on top of the light-receiving surface 20a. Another electrode 21b is provided on the rear surface 20b. More specifically, electrode 21b is provided on top of the transparent conductive film 25b formed on top of the rear surface 20b.

The electrodes 21a, 21b can be made of any conductive material. The electrodes 21a, 21b can be made, for example, of a metal such as silver, copper, aluminum, titanium, nickel or chrome, or an alloy including at least one of these metals. Also, the electrodes 21a, 21b may be formed by laminating a plurality of conductive layers of these metals or alloys.

There are no restrictions on the method used to form the electrodes 21a, 21b. The electrodes 21a, 21b can be formed using conductive paste such as Ag paste. Also, the electrodes 21a, 21b can be formed using a sputtering method, deposition method, screen printing method or plating method.

In the present embodiment, electrode 21b has substantially the same configuration as electrode 21a. Therefore, only the configuration of electrode 21a will be explained in detail. Electrode 21b is understood to be included into the explanation of electrode 21a.

Electrode 21a includes a plurality of linear electrode portions 31, trapezoidal electrode portions 32a, 32b, and busbar portions 33. Each of the linear electrode portions 31 are provided in the central portion 20a1. Each of the linear electrode portions 31 extend in the x direction, which is perpendicular to the y direction. The linear electrode portions 31 are arranged in the y direction. The plurality of linear electrode portions 31 are parallel to each other.

A trapezoidal electrode portion 32a is provided in a first end portion 20a2. The trapezoidal electrode portion 32a includes an upper floor portion 32a1, a lower floor portion 32a2, and a pair of oblique portions 32a3, 32a4. The upper floor portion 32a1 and the lower floor portion 32a2 extend in the x direction. The upper floor portion 32a1 is positioned to the outside relative to the y direction, and the lower floor portion 32a2 is positioned to the inside relative to the y direction. The upper floor portion 32a1 is shorter than the lower floor portion 32a2. The end portion of the upper floor portion 32a1 and the end portion of the lower floor portion 32a2 are connected, respectively, to the pair of oblique portions 32a3, 32a4. The pair of oblique portions 32a3, 32a4 extend along the edges of beveled corners 20A and 20B. In other words, oblique portions 32a3, 32a4 extend, respectively, in the x direction and y direction on an incline. In the present embodiment, the angle of the oblique portions 32a3, 32a4 relative to the x direction and the y direction is approximately 45°.

The trapezoidal electrode portion 32a also includes linear electrode portion 32a5. The linear electrode portion 32a5 is positioned in the y direction between the upper floor portion 32a1 and the lower floor portion 32a2. The linear electrode portion 32a5 extends in the x direction. The linear electrode portion 32a5 is connected in between the pair of oblique portions 32a3, 32a4.

Another trapezoidal electrode portion 32b is provided in a second end portion 20a3. The trapezoidal electrode portion 32b includes an upper floor portion 32b1, a lower floor portion 32b2, and a pair of oblique portions 32b3, 32b4. The upper floor portion 32b1 and the lower floor portion 32b2 extend in the x direction. The upper floor portion 32b1 is positioned to the outside relative to the y direction, and the lower floor portion 32b2 is positioned to the inside relative to the y direction. The upper floor portion 32b1 is shorter than the lower floor portion 32b2. The end portion of the upper floor portion 32b1 and the end portion of the lower floor portion 32b2 are connected, respectively, to the pair of oblique portions 32b3, 32b4. The pair of oblique portions 32b3, 32b4 extend along the edges of beveled corners 20C and 20D. In other words, oblique portions 32b3, 32b4 extend, respectively, in the x direction and y direction on an incline. In the present embodiment, the angle of the oblique portions 32b3, 32b4 relative to the x direction and the y direction is approximately 45°.

The trapezoidal electrode portion 32b also includes linear electrode portion 32b5. The linear electrode portion 32b5 is positioned in the y direction between the upper floor portion 32b1 and the lower floor portion 32b2. The linear electrode portion 32b5 extends in the x direction. The linear electrode portion 32b5 is connected in between the pair of oblique portions 32b3, 32b4.

In the present invention, rectangle is assumed to be included in "trapezoid".

There are no restrictions on the widths of the linear electrode portions 31, 32a5, 32b5, the upper floor portions 32a1, 32b1, the lower floor portions 32a2, 32b2, and the oblique portions 32a3, 32a4, 32b3, 32b4. Their widths can be from 50 µm to 200 µm. The widths of the linear electrode portions 31, 32a5, 32b5, the upper floor portions 32a1, 32b1, and the lower floor portions 32a2, 32b2 can be the same or different. There are also no restrictions on the distance between adjacent linear electrode portions 31 in the y direction. They can be spaced apart by a distance, for example, from 1 mm to 3 mm.

The plurality of busbar portions 33 extend in the y direction. The plurality of busbar portions 33 are arranged in the x direction. Each of the busbar portions 33 is connected electrically to the plurality of linear electrode portions 31, the upper floor portions 32a1, 32b1, the lower floor portions 32a2, 32b2, and linear electrode portions 32a5 and 32b5.

In the explanation of the present embodiment, the electrode 21a has two busbar portions 33. However, the present invention is not limited to this configuration. In the present invention, the electrode may have no busbar portions, one busbar portion, or three or more busbar portions. There are no restrictions on the width of the busbar portions 33. The width can range, for example, from 0.5 mm to 2 mm.

In the present embodiment, the busbar portions 33 are linear. However, in the present invention, the busbar portions do not have to be linear. For example, busbar portions can be provided with a zigzag shape.

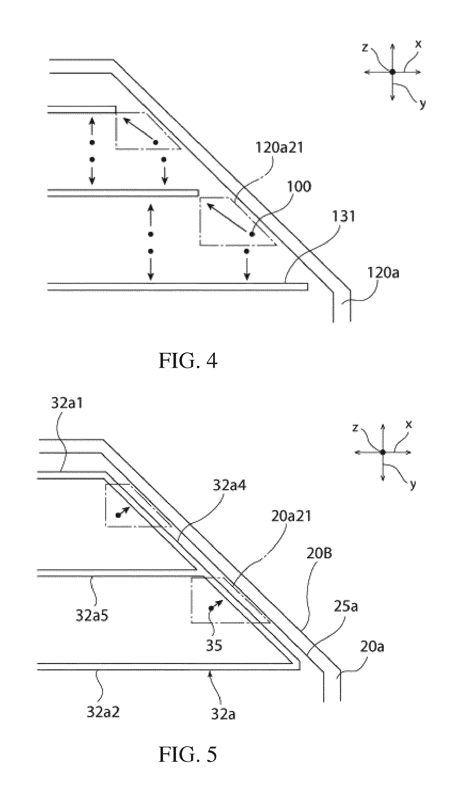

Also conceivable is the formation of a plurality of linear electrode portions in both the first and second end portions without providing trapezoidal electrode portions. In other words, it is also conceivable that the electrodes consist exclusively of a plurality of linear electrode portions, or a configuration comprising both linear electrode portions and busbar portions. In this case, electric resistance for current collection increases in the beveled corners. Therefore, the photoelectric conversion efficiency decreases. The reason will now be explained with reference to FIG. 4.

When a plurality of linear electrode portions 131 are provided in an end portion instead of a trapezoidal electrode portion, the carriers 100 are generated in non-adjacent regions 120a21 of the light-receiving surface 120a which are not adjacent to the linear electrode portions 131 in the y direction, and these carriers have to migrate a long distance before being collected by the linear electrode portions 131. This increases the collection resistance in the non-adjacent regions 120a21. As a result, photoconversion efficiency declines.

In the present embodiment, trapezoidal electrode portions 32a, 32b are provided in the end portions 20a2, 20a3. The trapezoidal electrode portions 32a, 32b include oblique portions 32a3, 32a4, 32b3, 32b4. The oblique portions 32a3, 32a4, 32b3, 32b4 extend along the edges of the beveled corners 20A-20D. Thus, as shown in FIG. 5, the carriers 35 generated in region 20a21 are collected by the oblique portions 32a3, 32a4, 32b3, 32b4. As a result, the carriers 35 only have to migrate a short distance before being collected by the electrode 21a. This can reduce collection resistance in region 20a21, and improve photoelectric conversion efficiency.

In the present embodiment, linear electrode portions 32a5, 32b5 are provided inside the trapezoidal electrode portions 32a, 32b. This more efficiently reduces collection resistance in the end portions 20a2, 20a3 located in the trapezoidal electrode portions 32a, 32b. As a result, improved photoelectric conversion efficiency can be realized.

A solar battery cell 10 in the present embodiment was prepared along with a solar battery cell having a substantially similar configuration to the solar battery cell 10 except without oblique portions, and the photoelectric conversion efficiency of both cells was measured. It was clear from the results that a solar battery cell 10 having oblique portions 32a3, 32a4, 32b3, 32b4 was approximately 1% more efficient in terms of photoelectric conversion than a solar battery cell without oblique portions.

The following is an explanation of additional examples and modifications that are preferred embodiments of the present invention. In the following explanation, members which perform substantially the same functions as those in the first embodiment are denoted by the same reference signs, and further explanation of these members is omitted.

### (1st Modification)

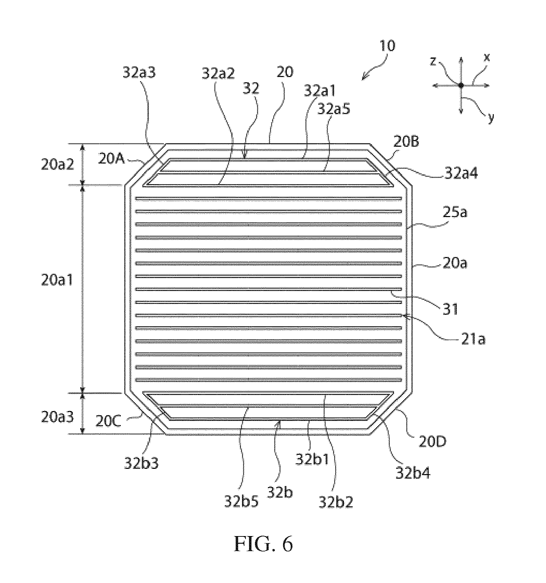

FIG. 6 is a schematic plan view of the light-receiving surface of the solar battery cell in a first modification.

In the explanation of the first embodiment, both of the electrodes 21a, 21b had more than one busbar portion. However, the present invention is not restricted to this configuration. For example, as shown in FIG. 6, electrode 21a does not have any busbar portion.

### (2nd Modification)

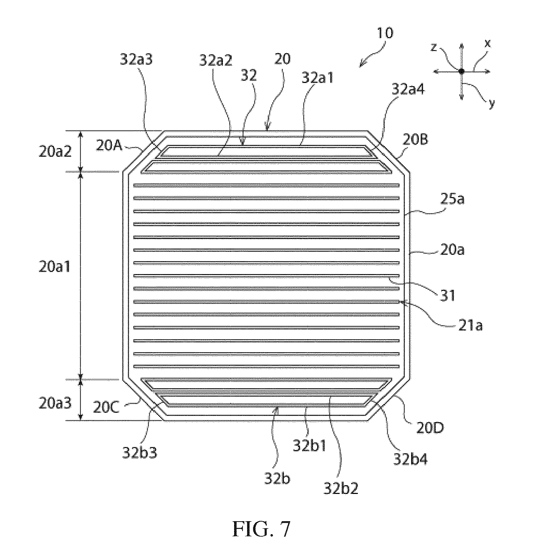

FIG. 7 is a schematic plan view of the light-receiving surface of the solar battery cell in a second modification.

In the explanation of the first embodiment, the first and second end portions 20a2, 20a3 each had one trapezoidal electrode portion 32a, 32b. However, the present invention is not restricted to this configuration. For example, as shown in FIG. 7, a plurality of trapezoidal electrode portions 32a may be arranged in direction y inside the first end portion 20a2. Similarly, a plurality of trapezoidal electrode portions 32b may be arranged in direction y inside the second end portion 20a3.

Also, linear electrode portions 32a5, 32b5 may be provided in the trapezoidal electrode portions 32a, 32b, or the linear electrode portions 32a5, 32b5 may be eliminated.

### (2nd Embodiment)

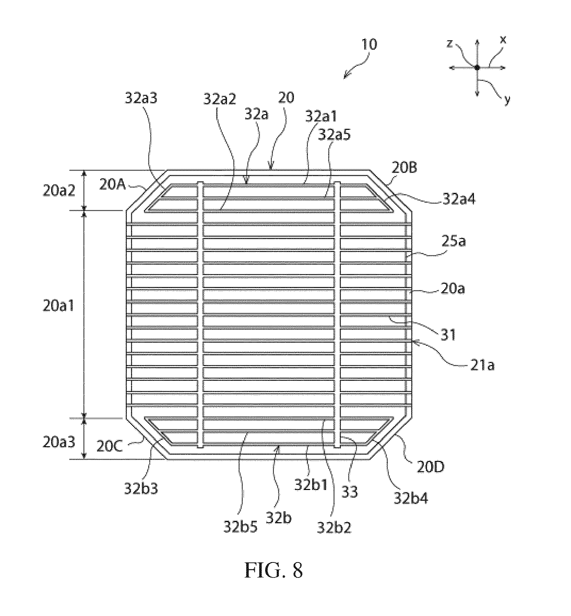

FIG. 8 is a schematic plan view of the light-receiving surface of the solar battery cell in a second embodiment.

In the explanation of the first embodiment, all of the linear electrode portions 31 were located on top of the transparent conductive film 25a, and the end portion of the linear electrode portions 31 did not extend to the edge of the transparent conductive film 25a.

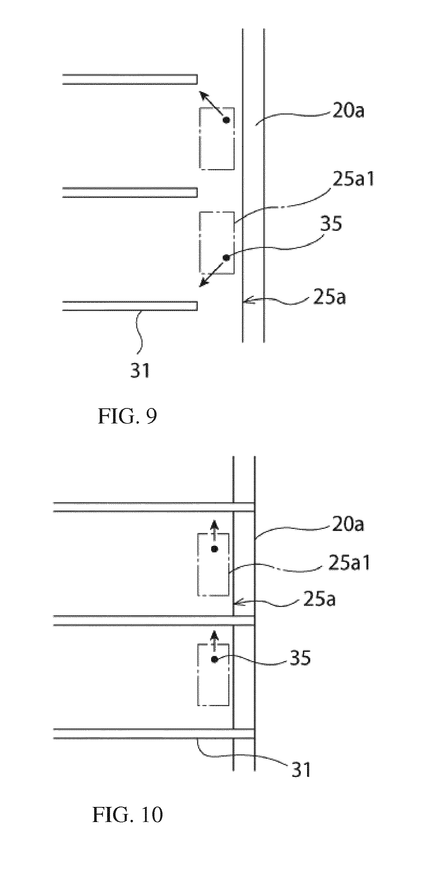

However, in the present embodiment, the end portions of the linear electrode portions 31 do extend to the edge of the transparent conductive film 25a. More specifically, the end portions of the linear electrode portions 31 extend to the edge of the photoelectric conversion unit 20. As a result, improved photoelectric conversion efficiency can be realized. The reason is explained below with reference to FIG. 9 and

FIG. 10.

When, as shown in FIG. 9, the end portions of the linear electrode portions 31 do not extend to the edge portion of the transparent conductive film 25a, the carriers generated in the edge portion 25a1 of the transparent conductive film 25a have to migrate a long distance before being collected by the linear electrode portions 31. This increases collection resistance on the edge portion 25a1. As a result, photoelectric conversion efficiency tends to decrease.

However, when, as shown in FIG. 10, the end portions of the linear electrode portions 31 do not extend to the edge portion of the transparent conductive film 25a, the carriers generated in the edge portion 25a1 of the transparent conductive film 25a migrate a short distance before being collected by the linear electrode portions 31. This can decrease collection resistance on the edge portion 25a1. As a result, photoelectric conversion efficiency can be improved.

More specifically, the solar battery cell in the present invention was created to measure the photoelectric conversion efficiency. It is clear from the results that the photoelectric conversion efficiency of the solar battery cell of the second embodiment, in which the end portions of the linear electrode portions 31 extend to the edge of the transparent conductive film 25a, is approximately 1% higher than the photoelectric conversion efficiency of the solar battery cell of the first embodiment, in which the end portions of the linear electrode portions 31 do not extend to the edge of the transparent conductive film 25a.

### (3rd Modification)

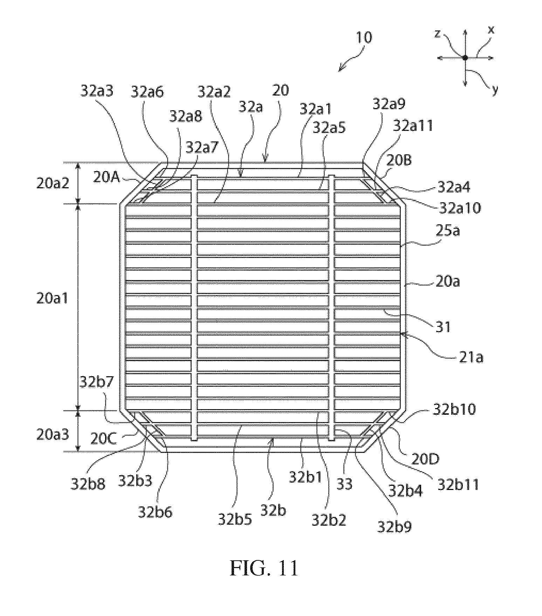

FIG. 11 is a schematic plan view of the light-receiving surface of the solar battery cell in a third modification. As shown in FIG. 11, the electrode 21a may also include linear electrode portions 32a6-32a11, 32b6-32b11 extending in the x direction from the end portions of upper floor portions 32a1, 32b1, the lower floor portions 32a2, 32b2, and the linear electrode portions 32a5, 32b5 to the edge portion of the transparent conductive film 25a. With this configuration, the collection resistance in the beveled corners 20A-20D can be further reduced. As a result, photoelectric conversion efficiency can be further improved.

The example explained in the first embodiment has an electrode 21a on the light-receiving surface 20a, and an electrode 21b on the rear surface 20b. However, the present invention is not limited to this configuration. In the present invention, at least one of the electrodes among the electrode on the light-receiving surface and the electrode on the rear surface should have a trapezoidal electrode portion. For example, the electrode on the light-receiving surface may include a trapezoidal electrode portion, and the electrode on the rear surface may not include a trapezoidal electrode portion. In this case, the electrode on the rear surface is a planar electrode.

Also, the electrode on the light-receiving surface may be a type of electrode shown in FIGS. 1, 6-8 or 11, and the electrode on the rear surface may be a type of electrode shown in FIGS. 1, 6-8 or 11 that is different from the type of electrode on the light-receiving surface. In other words, both the electrode on the light-receiving surface and the electrode on the rear surface may include a trapezoidal electrode portion, but the electrode on the light-receiving surface and the electrode on the rear surface are of different types.

### (3rd Embodiment)

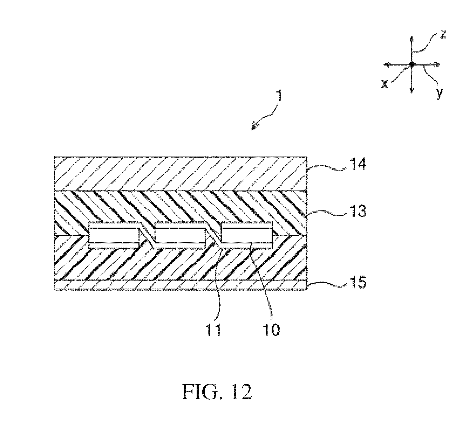

FIG. 12 is a schematic cross-sectional view of the solar battery cell in a third embodiment.

The solar battery cells 10 in the embodiments and modifications can be used in a solar battery module 1 as shown in FIG. 12. The solar battery module 1 in the present embodiment includes a plurality of solar battery cells 10 arranged in the y direction. The plurality of solar battery cells 10 are connected electrically by wiring 11. More specifically, the plurality of solar battery cells 10 are connected electrically in series or in parallel by connecting adjacent solar battery cells 10 to each other electrically by using wiring 11. More specifically, the wiring 11 is arranged so as to intersect the plurality of linear electrode portions 31, the upper floor portions 32a1, 32b1, and the lower floor portions 32a2, 32b2, and connected electrically to the electrode portions. When the electrodes 21a, 21b include busbar portions 33 as shown in FIG. 1 and FIG. 2, the wiring 11 is arranged so as to cover the top of the busbar portions 33.

In the present invention, orthogonal is included in "intersect".

The wiring 11 and the solar battery cells 10 are bonded using an adhesive. The adhesive can be solder or a resin adhesive. When a resin adhesive is used as the adhesive, the resin adhesive may have insulating properties, and may have anisotropic conductive properties.

First and second protective members 14, 15 are provided on the light-receiving surfaces and rear surfaces of the plurality of solar battery cells 10. A sealing material 13 is provided between the solar battery cells 10 and the first protective member 14 and between the solar battery cells 10 and the second protective member 15. The plurality of solar battery cells 10 are sealed using this sealing material 13.

There are no restrictions on the sealing material 13 and the material used in the first and second protective members 14, 15. The sealing material 13 can be a transparent resin such as a vinyl acetate copolymer (EVA) or polyvinyl butyral (PVB).

The first and second protective members 14, 15 can be molded from glass or a resin.

One of the first and second protective members 14, 15 can be metal foil such as aluminum foil interposed between resin film. In the present embodiment, the first protective member 14 is provided on the light-receiving surface of the solar battery cells 10. The first protective member 14 is made of glass or a transparent resin.

The second protective member 15 is arranged on the rear surface of the solar battery cells 10. The second protective member 15 consists of metal foil such as aluminum foil interposed between resin film. If necessary, a metal frame such as an aluminum frame (not shown) may be installed around the laminate of the first protective member 14, the sealing material 13, the plurality of solar battery cells 10, the sealing material 13, and the second protective member 15. If necessary, a terminal box is provided on the surface of the first protective member 14 for taking out the output of the solar battery cells 10.

### Key to the Drawings

1: Solar battery module
10: Solar battery cell
11: Wiring
13: Sealing material
14: 1 st protective member
15: 2nd protective member
20: Photoelectric conversion unit
20A-20D: Beveled corners
20a: Light-receiving surface
20a1: Central portion
20a2: 1st end portion
20a3: 2nd end portion
20b: Rear surface
21a, 21b: Electrodes
25a, 25b: Transparent conductive film
31: Linear electrode portion
32a, 32b: Trapezoidal electrode portion
32a1, 32b1: Upper floor portions
32a2, 32b2: Lower floor portions
32a3, 32a4, 32b3, 32b4: Oblique portions
32a5, 32b5: Linear electrode portions
33: Busbar portion

## Claims

1. A solar battery cell having a rectangular photoelectric conversion unit with beveled corners, and an electrode provided in the main surface of the photoelectric conversion unit;
the main surface including end portions having beveled corners in a first direction, and a central portion located closer to the center than the beveled corners in the first direction; and
the electrode having a plurality of linear electrode portions provided in the central portion and extending in a second direction perpendicular to the first direction, and a trapezoidal electrode portion provided in the end portion and including an upper floor portion and a lower floor portion provided in the end portion and extending in the second direction, the end portion of the upper floor portion being connected to the end portion of the lower floor portion, and a pair of oblique portions extending along the edge sides of a beveled corner.

2. The solar battery cell according to claim 1, wherein the trapezoidal electrode portion also includes a linear electrode portion positioned between the upper floor portion and the lower floor portion in the first direction and connected between the pair of oblique portions.

3. The solar battery cell according to claim 1 or claim 2, wherein the electrode also has at least one busbar portion electrically connecting the plurality of linear electrode portions to the upper floor portion and lower floor portion.

4. The solar battery cell according to any of claims 1 through 3, wherein the electrodes include a plurality of trapezoidal electrode portions.

5. The solar battery cell according to any of claims 1 through 4 further comprising planar transparent conductive film provided between the main surface and the electrode to cover the main surface except for the edge portions.

6. The solar battery cell according to claim 5, wherein the plurality of linear electrode portions are provided so as to reach an edge side of the transparent conductive film.

7. The solar battery cell according to claim 5 of claim 6, wherein the electrode also has an electrode portion extending in the second direction from at least one end portion of the upper floor portion and the lower floor portion to an edge side of the transparent conductive film.

8. The solar battery cell according to any of claims 1 through 7, wherein the main surface is a light-receiving surface.

9. A solar battery module comprising a plurality of solar battery cells according to any one of claims 1 through 8, and wiring for electrically connecting the plurality of solar battery cells;
the wiring provided so as to intersect the plurality of linear electrode portions.
